# EUROPEAN PATENT SPECIFICATION

(11) **EP 2 113 731 B1**
(45) Date of publication and mention of the grant of the patent: **02.02.2011**
(21) Application number: 08155483.4
(22) Date of filing: 30.04.2008
(51) Int. Cl.: F28F 13/14, H01L 37/04

(54) **Heat exchanger device**
Wärmetauschervorrichtung
Dispositif d'échangeur thermique

(43) Date of publication of application: 04.11.2009
(73) Proprietor: ABB Research LTD, 8050 Zürich (CH)
(72) Inventor: Russberg, Gunnar, 724 62, Västerås (SE)
(74) Representative: Dahlstrand, Björn

(56) References cited:
- EP-A- 1 033 167
- EP-A- 1 304 159
- DE-A1- 19 645 156
- DE-A1-102004 032 180
- FR-A- 2 097 056
- GB-A- 655 088
- US-A1- 2003 159 814
- KIROL L D ET AL: "numerical analysis of thermomagnetic generators" JOURNAL OF APPLIED PHYSICS, AMERICAN INSTITUTE OF PHYSICS. NEW YORK, US, vol. 56, no. 3, 1 August 1984 (1984-08-01), pages 824-828, XP002108300 ISSN: 0021-8979

## Description

### TECHNICAL FIELD OF THE INVENTION

The present invention generally relates to heat exchanger devices. The invention is preferably, but not exclusively, intended for a generator system for converting thermal energy to electric energy.

### DESCRIPTION OF RELATED ART AND BACKGROUND OF THE INVENTION

In known generator systems for converting thermal energy to electric energy there is provided a magnetic circuit of a suitable magnetic material and a coil arranged around the magnetic circuit. A temperature-varying arrangement varies the temperature of the magnetic circuit alternately above and below a phase transition temperature such as the Curie point of a magnetic material of the magnetic circuit to thereby vary the reluctance of the magnetic circuit and the resulting magnetization of the magnetic circuit is modulated by the varying reluctance so as to induce electric energy in the coil arranged around the magnetic circuit.

Such a generator is known from XP-002108300:"Numerical analysis of thermomagnetic generators", Journal of Applied Physics, vol. 56, no. 3.

The transfer of heat occurs in a porous core region of the magnetic circuit, which in the following is denoted cyclic heat exchanger. In conventional heat exchangers, heat is typically transferred from one fluid to another through a dividing solid wall. Contrary to such conventional use, in which the solid wall is a passive fluid separator and thermal connector/mediator, the purpose of the cyclic heat exchanger is to transfer heat between a single fluid and the solid wall itself.

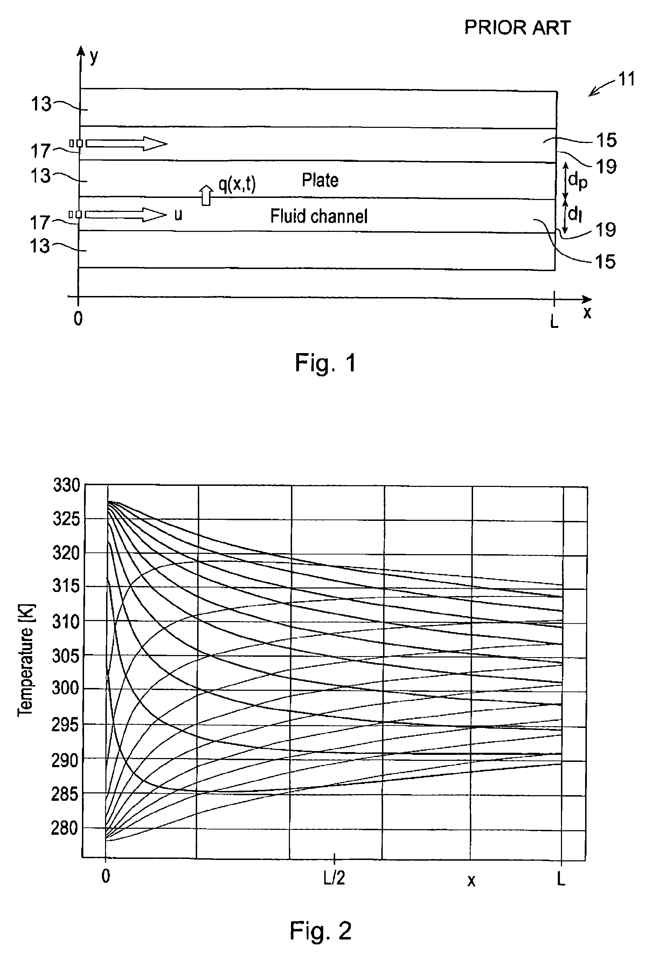

Fig. 1 shows such a cyclic heat exchanger 11 containing an active thermomagnetic material 13, in which channels 15 are provided for the thermal fluid transport. The thermomagnetic material 13 is provided as a set of parallel thin thermomagnetic plates of thickness dₚ, length L, and separation d_{f}.

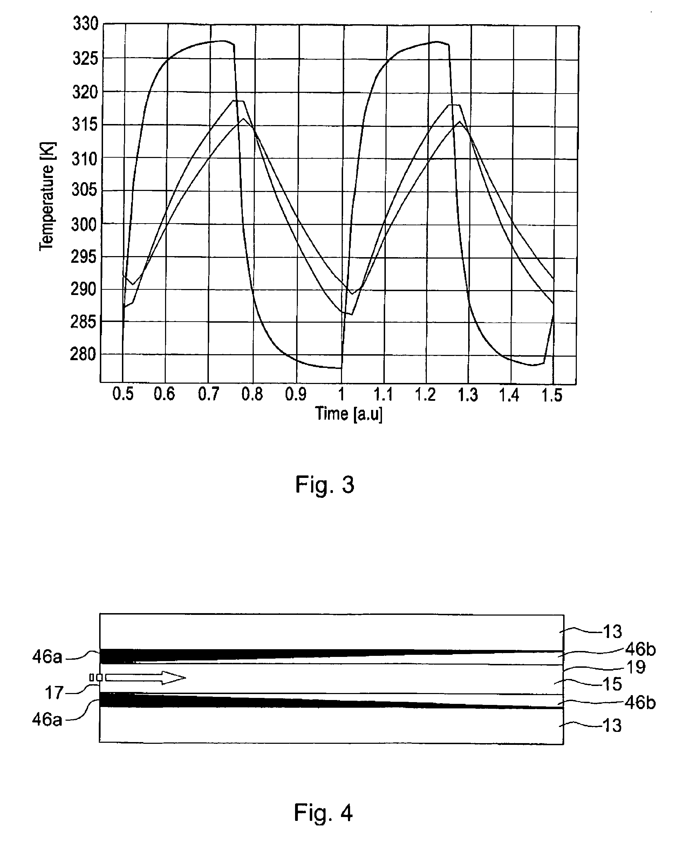

When feeding the cyclic heat exchanger 11 at the position where the inlets 17 are located, that is, x = 0, with a fluid of thermal inlet variation Tᵢ(t), e.g., in the form of an ideal square pulse train, alternating between temperatures T₁ and T₂ with frequency f, there will typically arise noticeably differences in temperature at different points along the x direction, even when the average fluid velocity is several times larger than f*L. The amplitude of the (local) temperature variation of the thermomagnetic material 13 decreases from a maximum at x = 0 to a minimum at the position where the outlets 19 are located, that is, x = L, due to the fact that the heat transfer is most effective near the left end at x = 0, where the temperature difference and heat transfer coefficient between fluid and plate 13 are the highest. Further along the flow direction, the fluid has lost more and more of its initial thermal content (hot or cold) and the distance from the plate 13 to the less affected/degraded part of the fluid deeper inside the channel 15 has increased. The temperature variation in the center of a plate 13 of the cyclic heat exchanger 11 as a function of the distance x is shown in Fig. 2 for different points of time over a full period of the thermal cycle. The temporal temperature variation in the plate center at three different positions along the x direction is shown in Fig. 3. The temporal behaviour is shown at x = 0, x = L/2, and x = L. It can bee seen from Figs. 2 and 3 that not only the amplitude of the temperature varies along the cyclic heat exchanger 11, but also the phase of the temperature varies along the cyclic heat exchanger 11.

The heat cycling characteristics of the above described cyclic heat exchanger is clearly unacceptable for a thermomagnetic generator.

### SUMMARY OF THE INVENTION

It is therefore an object of the present invention to provide a heat exchanger device, by which the above described drawbacks and limitations associated with the known device are eliminated or at least alleviated.

It is a particular object of the invention to provide such heat exchanger device, which can be used efficiently in a thermomagnetic generator system that converts thermal energy to electric energy.

These objects, among others, are according to the present invention attained by heat exchanger devices as specified in the appended patent claims.

According to one aspect of the invention there is provided a heat exchanger device, which comprises a body and at least one channel located in the body, through which a heat exchange fluid is adapted to be guided, thereby providing heat transfer per unit area between the heat exchange fluid and the material of the body. The body has a material composition and/or dimensions such that the amount of heat transfer per unit area between the heat exchange fluid and the thermomagnetic material of the body is essentially constant or even along the direction of the channel. The material of the body comprises a thermomagnetic material.

The body comprises in one main embodiment a layer, preferably a thermally insulating layer, facing said at least one channel, the layer having a heat transfer capability per unit area that varies along the channel. The varying heat transfer capability per unit area can be achieved by the layer having a varying thickness or material composition along the channel.

In the latter instance, the layer may comprise a binary mixture of materials having different heat conductivity properties wherein the volume fractions of the materials of the binary mixture are varied along the channel.

In another main embodiment the constant heat transfer per unit area between the heat exchange fluid and the thermomagnetic material of the body along the direction of the channel is achieved by an inhomogeneous structure of the bulk material of the body. The body and the at least one channel are hereby designed with a channel-body interface surface area that increases along the channel in a flow direction of the heat exchange fluid.

In one realization the body comprises a plurality of plates in contact with the at least one channel, wherein the plates have a varying extension along the channel.

In another realization the body comprises a plurality of grains or similar in contact with the at least one channel, wherein the grains have a size that varies along the channel.

The present invention features a cyclic heat exchanger device, which is simple, reliable, and robust, and by which temperature variations along the heat exchanger device can be essentially eliminated.

The heat exchanger device of the present invention can be used in a thermomagnetic generator system or can be used in entirely different applications, in which temperature gradients along the heat exchanger should be avoided. In the former case, the material of the body comprises thermomagnetic material such as e.g. gadolinium.

Further characteristics of the invention and advantages thereof, will be evident from the following detailed description of preferred embodiments of the present invention given hereinafter and the accompanying Figs. 4-9, which are given by way of illustration only and thus, are not limitative of the present invention.

### BRIEF DESCRIPTION OF THE DRAWINGS

Fig. 1 displays schematically in a cross-sectional side view a heat exchanger device according to prior art.
Fig. 2 is a diagram of the temperature in the center of a plate of the heat exchanger of Fig. 1 as a function of distance along the cyclic heat exchanger for different points of time over a full period of a thermal cycle.
Fig. 3 is a diagram of the temperature in the center of a plate of the cyclic heat exchanger of Fig. 1 as a function of time for three different positions along the cyclic heat exchanger.
Figs. 4-5 display each schematically in a cross-sectional side view a heat exchanger device according to a respective embodiment of the invention.
Fig. 6 is a diagram of the temperature in the center of a plate of the heat exchanger of Fig. 4 as a function of distance along the cyclic heat exchanger for different points of time over a full period of a thermal cycle.
Fig. 7 is a diagram of the temperature in the center of a plate of the cyclic heat exchanger of Fig. 4 as a function of time for three different positions along the cyclic heat exchanger.
Figs. 8-9 display each schematically in a cross-sectional side view a heat exchanger device according to a respective further embodiment of the invention.

### DETAILED DESCRIPTION OF EMBODIMENTS

Fig. 4 displays a heat exchanger device according to an embodiment of the invention. The heat exchanger device comprises a body 13 and at least one channel 15 located in the body 13, through which a heat exchange fluid is adapted to be guided, thereby providing heat transfer between the heat exchange fluid and the material of the body 13. The body can have virtually any shape but is illustrated as being comprised of parallel plates.

The heat exchange fluid may be provided in the form of a pulse train, alternating between different temperatures at a given frequency. In such instance, the heat exchanger device is referred to as a cyclic heat exchanger device.

If such cyclic heat exchanger device is to be used in a generator system of an electric power plant for converting thermal energy to electric energy, the body 13 is made of or comprises a thermomagnetic material such as e.g. gadolinium.

The heat exchanger device comprises further surface layers 46a facing the channel 15, the surface layers 46a having a heat transfer capability per unit area that varies along the channel 15 such that the amount of heat transfer per unit area between the heat exchange fluid and the body 13 is essentially constant or even along the channel 15.

Preferably, the surface layers 46a are each a thermally insulating layer and the varying heat transfer capability per unit area is achieved by the surface layers 46a having a varying, i.e. decreasing, thickness along the channel 15 as seen along the flow direction of the heat exchange fluid. Hereby, the heat transfer between the heat exchange fluid and the body 13 is artificially delayed at the fluid-body interface.

The heat exchanger device may comprise further layers 46b, which are thermally conducting and have an increasing thickness along the channel 15 as seen along the flow direction of the heat exchange fluid so that the total thickness of the layers 46a-b remain essentially constant along the channel 15. Hereby, the flow of the heat exchange fluid is not affected adversely.

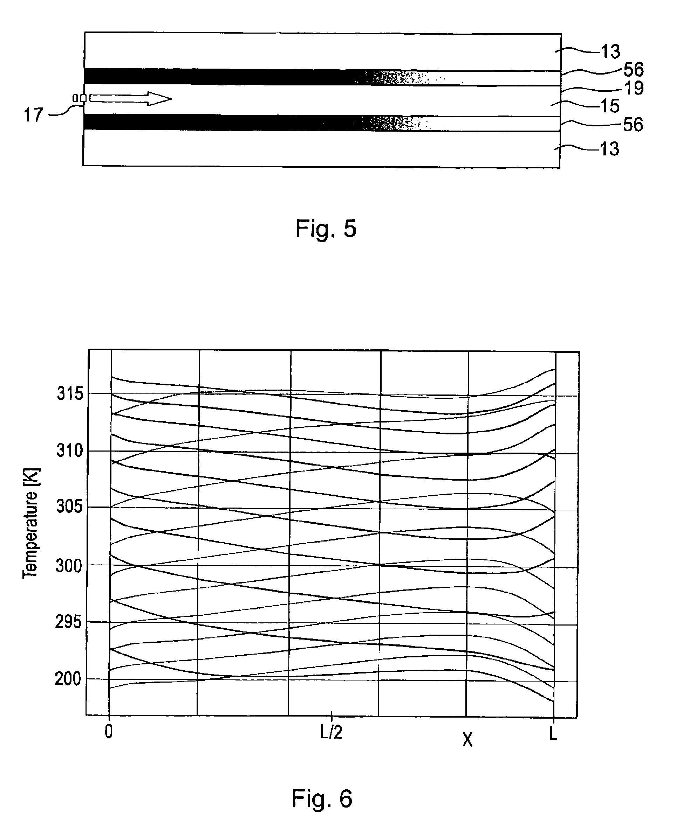

Alternatively, as being illustrated in Fig. 5, the varying heat transfer capability per unit area is achieved by the surface layers, here denoted 56, having a varying material composition along the channel 15. For instance, the surface layers 56 may comprise a binary mixture of materials having different heat conductivity properties, wherein the volume fractions of the materials of the binary mixture are varied along the channel 15.

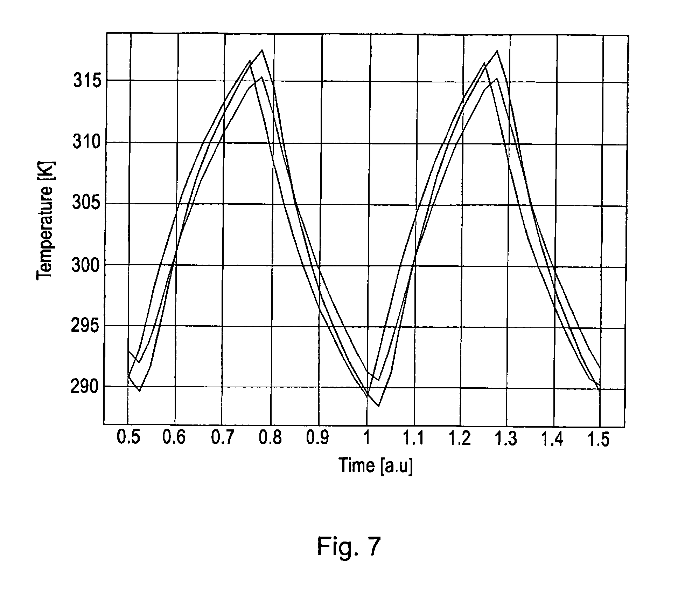

Figs. 6 and 7 show simulation results for a cyclic heat exchange device like the one in Fig. 5. Fig. 6 shows the temperature variation in the center of a plate 13 of the cyclic heat exchanger as a function of the distance x along the channel 15 for different points of time over a full period of a thermal cycle of a temperature varying heat exchange fluid.
Fig. 7 shows the temporal temperature variation in the plate center at three different positions along the x direction, at x = 0, x = L/2, and x = L.

It can bee seen from Figs. 6 and 7 that the amplitude and phase of the temperature are essentially constant along the cyclic heat exchanger. The simulation results (resembling a "realistic" case with 1 mm thick metallic gadolinium plates coated with a thin, graded epoxy layer) show that a technically feasible solution is possible, which is easy to apply and which has only a limited impact on the fluid channel width and on the efficiency of the heat exchanger device. The insulation material might e.g. be based on epoxy which provides thermal conductivities down to about 0.15 W/Km. Solid insulating materials exist with a thermal conductivity considerably below 0.1 W/Km, allowing the maximum layer thickness to be as low as 10-20 µm.

Further, the presence of the surface layers is beneficial in that it simultaneously can be designed to protect the cyclic heat exchanger material from corrosion and mechanical wear out as well as delaying the thermal transfer.

The heat exchanger device may comprise thermally insulating plates/sidewalls and instead comprise granular heat exchange material in the channel and allow the heat exchange fluid to pass through the voids between the particles (not illustrated). The particles, e.g., small spheres, grains or pellets (that are here the body of the heat exchanger device), may have a size in the range 0.1-1 mm. The present invention may in such a device be realized by providing the particles with thermally insulating layers, wherein the thermally insulating layers of the particles have a thickness and/or a material composition that vary/ies along the channel.

While the above embodiments are based on a uniform structure of the heat exchange material along the channel where a thermal delay or resistance is added to a decreasing extent along the channel in the direction of the flow of the heat exchange fluid, the invention may instead be realized by means of providing the heat exchange material in a non-uniform structure along the channel such that the channel-body or heat exchange fluid-material interface surface area varies along the channel, i.e. increases in the direction of the flow of the heat exchange fluid.

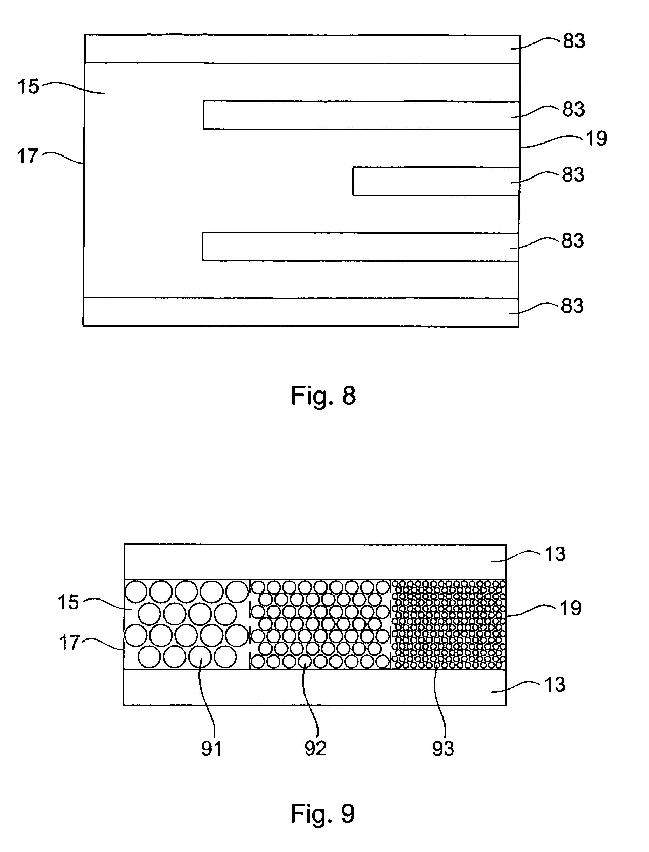

Fig. 8 illustrates a heat exchange device comprising a plurality of plates 83 in contact with the channel area 15, wherein the plates 83 have varying extensions along the channel area 15. That is, there are more plates 83 in a downstream end 19 of the heat exchange device as compared to an upstream end 17 thereof. As a result, the fluid-solid interfacial surface area is increased along the flow. Preferably however, the plate:fluid area ratio or plate density is kept fairly constant along the channel area 15. The average thermal transfer rate is improved to the cost of increased fluid flow resistance.

In order to improve the flow properties and thus the operation of the heat exchange device the intermediate plates may be designed with tapered ends facing the flowing heat exchange fluid and the outermost plates may be arranged with a varying distance in between them in order to achieve an essential similar cross sectional area of the channel area 15 along the heat exchange device.

In an alternative embodiment, as being illustrated in Fig. 9, if the heat exchanger device comprises thermally insulating plates/sidewalls 15, granular heat exchange material of a varying size may be provided in the channel 15. To obtain an increasing fluid-solid interfacial surface area along the flow, the particle size is gradually decreasing along the flow.

In the illustrated embodiment the particles are provided in three different sizes along the channel 15. In an upstream end section 91 the particles are provided in a largest size, in an intermediate section 92 the particles are provided in a smaller size, and in a downstream end section 93 the particles are provided in the smallest size.

Yet alternatively, the increasing fluid-solid interfacial surface area along the flow can be obtained by an increased surface roughness of the channel walls along the flow, or by an increased density of mixing obstacles along the flow to increase the amount of turbulence and thus heat exchange.

An advantage of the present invention is that a significant reduction of thermal gradients is achieved. A nearly optimum temperature distribution provides for the use of a heat exchanger device with a unidirectional continuous flow of heat exchange fluid. Further, a single heat exchange material/substance can be used. Such advantages are not at least important for a cyclic heat exchanger in a generator system of an electric power plant for converting thermal energy to electric energy.

It shall be appreciated by a person skilled in the art that various features of the embodiments described above may be combined to reach yet further embodiments of the invention.

## Claims

1. A heat exchanger device comprising:
- a body (13) and at least one channel (15) located in said body, through which a heat exchange fluid is adapted to be guided, thereby providing heat transfer per unit area between said heat exchange fluid and the material of said body, wherein
the material of said body comprises a thermomagnetic material, **characterized in that**
said body has a material composition and/or dimensions such that the amount of heat transfer per unit area between said heat exchange fluid and the material of said body is essentially constant along the direction of said at least one channel.

2. The device of claim 1 wherein the body comprises a layer (46a, 56) facing said at least one channel, the layer having a heat transfer capability per unit area that varies along said at least one channel.

3. The device of claim 2 wherein said layer is a thermally insulating layer (46a).

4. The device of claim 2 or 3 wherein said varying heat transfer capability per unit area is achieved by said layer (46a) having a varying thickness along said at least one channel.

5. The device of claim 2 or 3 wherein said varying heat transfer capability per unit area is achieved by said layer (56) having a varying material composition along said at least one channel.

6. The device of claim 5 wherein said layer comprises a binary mixture of materials having different heat conductivity properties wherein the volume fractions of the materials of the binary mixture vary along said at least one channel.

7. The device of claim 1 wherein said body and said at least one channel are designed with a channel-body interface surface area that varies along said at least one channel.

8. The device of claim 7 wherein said body comprises a plurality of plates (83) in contact with said at least one channel, said plates having a varying extension along said at least one channel.

9. The device of claim 7 wherein said body comprises a plurality of particles (91-93) in contact with said at least one channel, said particles having a size that varies along said at least one channel.

10. The device of any of claims 1-9 wherein said thermomagnetic material comprises gadolinium.

11. The device of any of claims 1-10 wherein the heat exchange fluid has a periodically varying temperature at the inlet to said channel.

12. A generator system for converting thermal energy to electric energy comprising the device of any of claims 1-11.

13. An electric power plant comprising the generator system of claim 12.

14. Use of the device of any of claims 1-11 in a method or system for producing electric power.

## Patentansprüche

1. Eine Wärmetauschvorrichtung umfassend:
• einen Körper (13)und zumindest einen Kanal (15), der sich in dem Körper befindet, wobei ein Wärmetauschfluid geeignet ist, durch diesen geführt zu werden, dabei Bereitstellen von Wärmetransfer pro Flächeneinheit zwischen dem Wärmetauschfluid und dem Material des Körpers, wobei das Material des Körpers ein thermomagnetisches Material umfasst, **dadurch gekennzeichnet dass**
• der Körper eine Materialzusammensetzung und/oder Dimensionen aufweist, so dass der Betrag des Wärmetransfers pro Flächeneinheit zwischen dem Wärmetauschfluid und dem Material des Körpers im Wesentlichen konstant ist entlang der Richtung des zumindest einen Kanals.

2. Die Vorrichtung nach Anspruch 1, wobei der Körper eine Schicht (46a, 56) umfasst, die dem zumindest einen Kanal zugewandt ist, wobei die Schicht eine Wärmetransferfähigkeit pro Flächeneinheit aufweist, die entlang des zumindest einen Kanals variiert.

3. Die Vorrichtung nach Anspruch 2, wobei die Schicht eine thermisch isolierende Schicht (46a) ist.

4. Die Vorrichtung nach Anspruch 2 oder 3, wobei die variierende Wärmetransferfähigkeit pro Flächeneinheit durch die Schicht (46a) erreicht wird, die eine variierende Dicke entlang des zumindest einen Kanals aufweist.

5. Die Vorrichtung nach Anspruch 2 oder 3, wobei die variierende Wärmetransferfähigkeit pro Flächeneinheit durch die Schicht (56) erreicht wird, die eine variierende Materialzusammensetzung entlang des zumindest einen Kanals aufweist.

6. Die Vorrichtung nach Anspruch 5, wobei die Schicht eine binäre Mischung von Materialien umfasst, die unterschiedliche Wärmeleiteigenschaften aufweisen, wobei die Volumenanteile der Materialien der binären Mischung entlang des zumindest einen Kanals variieren.

7. Die Vorrichtung nach Anspruch 1, wobei der Körper und der zumindest eine Kanal mit einer Kanal-Körper-Schnittstellenoberflächenfläche ausgebildet sind, die entlang des zumindest einen Kanals variiert.

8. Die Vorrichtung nach Anspruch 7, wobei der Körper eine Vielzahl von Platten (83) in Kontakt mit dem zumindest einen Kanal umfasst, wobei die Platten eine variierende Ausdehnung entlang des zumindest einen Kanals aufweisen.

9. Die Vorrichtung nach Anspruch 7, wobei der Körper eine Vielzahl von Partikeln (91-93) in Kontakt mit dem zumindest einen Kanal umfasst, wobei die Partikel eine Größe aufweisen, die entlang des zumindest einen Kanals variiert.

10. Die Vorrichtung nach einem der Ansprüche 1-9, wobei das thermomagnetische Material Gadolinium umfasst.

11. Die Vorrichtung nach einem der Ansprüche 1-10, wobei das Wärmetauschfluid eine periodisch variierende Temperatur am Eingang zum Kanal aufweist.

12. Ein Generatorsystem zum Konvertieren von thermischer Energie in elektrische Energie umfassend die Vorrichtung nach einem der Ansprüche 1-11.

13. Ein elektrisches Kraftwerk umfassend das Generatorsystem von Anspruch 12.

14. Verwendung der Vorrichtung nach einem der Ansprüche 1-11 in einem Verfahren oder System zum Erzeugen von elektrischer Energie.

## Revendications

1. Dispositif formant échangeur de chaleur et comprenant :
- un corps (13) et au moins un canal (15) qui est situé dans le corps et dans lequel un fluide d'échange de chaleur est conçu pour être guidé, en procurant ainsi un transfert de chaleur par unité de surface entre le fluide d'échange de chaleur et le matériau du corps, dans lequel le matériau du corps comprend un matériau thermomagnétique, **caractérisé en ce que** le corps a une composition de matériau et/ou des dimensions telles que la quantité de transfert de la chaleur par unité de surface entre le fluide d'échange de chaleur et le matériau du corps est sensiblement constante le long de la direction du au moins un canal.

2. Disposition suivant la revendication 1, dans lequel le corps comprend une couche (46a, 56) faisant face au au moins un canal, la couche ayant une capacité de transfert de la chaleur par unité de surface qui varie le long du au moins un canal.

3. Disposition suivant la revendication 2, dans lequel la couche est une couche (46a) isolante du point de vue thermique.

4. Disposition suivant la revendication 2 ou 3, dans lequel la capacité variable de transfert de la chaleur par unité de surface est obtenue par le fait que la couche (46a) a une épaisseur variable le long du au moins un canal.

5. Disposition suivant la revendication 2 ou 3, dans lequel la capacité variable de transfert de la chaleur par unité de surface est obtenue par le fait que la couche (56) a une composition de matériau variable le long du au moins un canal.

6. Disposition suivant la revendication 5, dans lequel la couche comprend un mélange binaire de matériaux ayant des propriétés de conductivité de la chaleur qui sont différentes, des fractions en volume des matériaux du mélange binaire variant le long du au moins un canal.

7. Disposition suivant la revendication 1, dans lequel le corps et le au moins un canal sont conçus en ayant une aire de la surface d'interface canal-corps, qui varie le long du au moins un canal.

8. Disposition suivant la revendication 7, dans lequel le corps comprend une pluralité de plateaux (83) en contact avec le au moins un canal, les plateaux ayant une étendue variable le long du au moins un canal.

9. Disposition suivant la revendication 7, dans lequel le corps comprend une pluralité de particules (91 à 93) en contact avec le au moins un canal, les particules ayant une dimensions qui varie le long du au moins un canal.

10. Dispositif suivant l'une quelconque des revendications 1. à 9, dans lequel le matériau thermomagnétique comprend du gadolinium.

11. Dispositif suivant l'une quelconque des revendications 1 à 10, dans lequel le fluide d'échange de la chaleur a une température variable périodiquement à l'entrée du canal.

12. Système de génératrice pour transformer de l'énergie thermique en de l'énergie électrique, comprenant le dispositif suivant l'une quelconque des revendications 1 à 11.

13. Centrale électrique comprenant le système de génératrice de la revendication 12.

14. Utilisation du dispositif suivant l'une quelconque des revendications 1 à 11, dans un procédé ou dans un système pour produire de l'électricité.
